(19) Europäisches Patentamt
European Patent Office
Office européen des brevets

(11) **EP 1 970 745 A2**

(12) **EUROPÄISCHE PATENTANMELDUNG**

(43) Veröffentlichungstag:
**17.09.2008 Patentblatt 2008/38**

(51) Int Cl.:
**G02B 21/06** *(2006.01)*

(21) Anmeldenummer: **08002910.1**

(22) Anmeldetag: **16.02.2008**

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**
Benannte Erstreckungsstaaten:
**AL BA MK RS**

(30) Priorität: **14.03.2007 DE 102007012951**

(71) Anmelder: **Carl Zeiss Surgical GmbH
73447 Oberkochen (DE)**

(72) Erfinder:
• **Matz, Holger
73485 Unterschneidheim (DE)**
• **Moffat, Bryce Anton
07743 Jena (DE)**

(74) Vertreter: **Gauss, Nikolai
c/o Carl Zeiss AG
Patentabteilung
Carl-Zeiss-Strasse 22
73447 Oberkochen (DE)**

(54) **Beleuchtungsmodul insbesondere für Operationsmikroskop**

(57) Die Erfindung betrifft ein Beleuchtungsmodul 100 mit einer Lichtquelle, die wenigstens eine Weißlicht-LED aufweist. Erfindungsgemäß ist zusätzlich zur Weißlicht-LED eine LED fiir Rotlicht und eine LED für Grünlicht vorgesehen. Das Beleuchtungsmodul 100 enthält eine Lichtmischeinrichtung 107, die das Licht der Weißlicht-LED mit Licht der LED für Rotlicht und der LED für Grünlicht vermischt, um an einem Ausgang 112 des Beleuchtungsmoduls für Beleuchtungslicht weißes Beleuchtungslicht bereitzustellen.

fig. 1

EP 1 970 745 A2

**Beschreibung**

Die Erfindung betrifft ein Beleuchtungsmodul mit einer Lichtquelle, die wenigstens eine Weißlicht-LED aufweist.

Um einem Operateur in einem Operationsmikroskop den Operationsbereich hell und mit guten Kontrast sichtbar zu machen, muss der Operationsbereich mit einer intensitätsstarken und farbechten Lichtquelle beleuchtet werden.

Es ist bekannt, hierzu als Lichtquellen Halogenlampen und Xenonlampen einzusetzen. Solche Lichtquellen wirken als Temperaturstrahler. Eine Halogenlampe erzeugt Licht mit einer spektralen Intensität, das in etwa derjenigen des schwarzen Strahlers bei einer Temperatur T im Bereich von T = 2800° K bis T = 3200° K entspricht. Eine Xenonlampe gibt Licht mit einer spektralen Intensität ab, die in etwa derjenigen eines schwarzen Strahlers der Temperatur T = 4800° K gleicht.

Xenon- oder Halogenlampen als Lichtquellen haben als thermische Strahler den Nachteil, dass die Lichterzeugung mit einer starken Temperaturentwicklung verbunden ist. Die Lebensdauer dieser Lampen ist deshalb begrenzt und die spektrale Intensität des von den Lampen abgegebenen Lichts über die Lebensdauer hinweg ist nicht konstant.

Beleuchtungsmodule, die Licht durch LEDs erzeugen, weisen diese Nachteile nicht auf. LEDs vermögen mit vergleichsweise geringer elektrischer Leistung Licht zu erzeugen, ohne dass dabei so viel Wärme wie bei thermischen Strahlern entwickelt wird. Im Vergleich zu Xenon- und Halogenlampen sind LEDs kostengünstiger herzustellen und lassen sich über eine längere Lebensdauer betreiben.

In LEDs wird Licht durch Elektroluminiszenz erzeugt, die dadurch entsteht, dass in der Leuchtdiode Ladungsträger von einem Quantenzustand in einem anderen Quantenzustand übergehen und dabei Energie abgeben, die in Licht verwandelt wird. Das Wellenlängenspektrum von mittels Elektroluminiszenz erzeugtem Licht ist deshalb im Vergleich zu einem Temperaturstrahler schmalbandig.

Um mittels LEDs Weißlicht zu erzeugen, ist es bekannt, entweder das Licht aus drei oder mehr verschiedenfarbigen Leuchtdioden der Farben Rot, Grün und Blau einander zu überlagern oder das schmalbandige, mittels Elektroluminiszenz erzeugte Licht zu Weißlicht zu konvertieren, etwa indem phosphorhaltiges Konvertermaterial mit Licht einer blauen LED durchstrahlt wird. Wird das Licht von LEDs unterschiedlicher Farben zu Weißlicht vermischt, so kann durch Variieren der von den einzelnen LEDs abgegebenen Lichtintensität die Farbtemperatur des resultierenden Weißlichts eingestellt werden. Dabei wird unter der Farbtemperatur einer Lichtquelle diejenige Farbtemperatur des Schwarzen Strahlers verstanden, die ihm den Farbeindruck der Lichtquelle verleiht.

Beleuchtungsmodule, die durch Mischen des Lichts von Leuchtdioden der Farben Rot, Grün und Blau Weißlicht erzeugen oder in denen Weißlicht dadurch generiert wird, dass das Licht einer blauen LED durch phosphorhaltiges Konvertermaterial geführt wird, vermögen nur Weißlicht zu erzeugen, dessen sogenannter CRI-Wert gegenüber dem von Weißlicht aus einer Halogenlichtquelle bzw. Xenonlichtquelle klein ist.

Dabei wird vorliegend unter dem CRI-Wert des vom Beleuchtungsmodul abgegebenen Weißlichts der im Formelausdruck 19.9 auf S. 317 in E. Fred Schubert, Light Emitting Diodes, Cambridge University Press, Second Edition 2006 angegebene Zahlenwert verstanden, der im Bezug auf eine Referenzlichtquelle ein Maß für die Farbtreue einer mit dem Beleuchtungsmodul als Lichtquelle beleuchteten normierten Farbtafel ist. Der CRI-Wert ist dabei im folgenden auf einen thermischen Schwarzkörperstrahler der Temperatur T = 4800° K bezogen.

Für aus dem Stand der Technik bekannte Beleuchtungsmodule, die Weißlicht durch Überlagern des Lichts aus einer roten (R), grünen (G) und blauen (B) LED erzeugen, gilt:

$$CRI_{LED-Lichtquelle} < 80$$

Aufgabe der Erfindung ist es, ein Operationsmikroskop-Beleuchtungsmodul zu schaffen, in dem Licht mittels LEDs erzeugt wird und das weißes Beleuchtungslicht mit variabler Farbtemperatur bei gleichzeitig maximalem CRI-Wert bereitzustellen vermag, wobei gilt:

$$CRI_{Beleuchtungs\,modul} > 80$$

Diese Aufgabe wird durch ein Beleuchtungsmodul der eingangs genannten Art gelöst, bei dem eine LED für Rotlicht (R) und eine LED für Grünlicht (G) vorgesehen ist, wobei das Beleuchtungsmodul eine Lichtmischeinrichtung enthält, die das Licht der Weißlicht-LED mit Licht der LED für Rotlicht (R) und der LED für Grünlicht (G) vermischt, um an einem Ausgang des Beleuchtungsmoduls weißes Beleuchtungslicht bereitzustellen.

Auf diese Weise wird ein Beleuchtungsmodul geschaffen, das Weißlicht zur Verfügung stellt, wobei die Farbwiedergabe dieses Weißlichts gegenüber dem mit Weißlicht-LEDs oder mit RGB-LEDs erzeugtem Weißlicht verbessert ist und damit einer Beobachtungsperson über einen breiten Farbereich ein natürlicher Seheindruck ermöglicht wird.

In Weiterbildung der Erfindung ist eine Steuereinheit vorgesehen, um die von einer jeden LED abgegebene Lichtintensität zu steuern. Auf diese Weise ist es möglich, die spektrale Intensität des vom Beleuchtungsmodul abgegebenen Beleuchtungslichts einzustellen.

In Weiterbildung der Erfindung ist der Steuereinheit ein Datenspeicher zugeordnet, der für unterschiedliche Farbtemperaturen den erforderlichen Strom der LED für Weißlicht, der LED für Rotlicht und der LED für Grünlicht enthält, um mit dem Beleuchtungsmodul Weißlicht der betreffenden Farbtemperatur beim maximalem CRI-Wert zu erzeugen. Auf diese Weise lässt sich die Farbwiedergabe bei dem Beleuchtungsmodul optimieren.

In Weiterbildung der Erfindung weist das Beleuchtungsmodul eine Eingabeeinheit zur Eingabe einer gewünschten Farbtemperatur des von dem Beleuchtungsmodul abgegebenen Weißlichts auf. Auf diese Weise kann die Farbtemperatur des mit dem Beleuchtungsmodul erzeugten Weißlichts an die Erfordernisse eines beobachteten Objektbereichs angepasst werden.

Eine vorteilhafte Ausführungsform der Erfindung ist in den Zeichnungen dargestellt und wird nachfolgend beschrieben.

Es zeigen:

Fig. 1    eine schematische Ansicht des erfindungsgemäßen Beleuchtungsmoduls;

Fig. 2    ein Chip-Mischmodul mit zwei Weißlicht-LEDs und einer roten (R) LED sowie einer grünen (G) LED;

Fig. 3    den schematischen Aufbau einer Weißlicht-LED im Chip-Mischmodul;

Fig. 4    den schematischen Aufbau einer Rotlicht (R) LED bzw. einer Grünlicht (G) LED im Chip-Mischmodul;

Fig. 5    die spektrale Intensität des von dem Beleuchtungsmodul abgegebenen Weißlichts für unterschiedlich gewählte Farbtemperaturen;

Fig. 6    einen Ausschnitt des Farbdreiecks nach dem CIE-Standard mit Farbwerten für Licht aus dem Chip-Mischmodul;

Fig. 7    CRI-Werte für Weißlicht aus dem Chip-Mischmodul, die auf einen thermischen Schwarzkörperstrahler der Temperatur T = 4800° K bezogen sind; und

Fig. 8    ein Operationsmikroskop mit dem Beleuchtungsmodul als Beleuchtungseinrichtung.

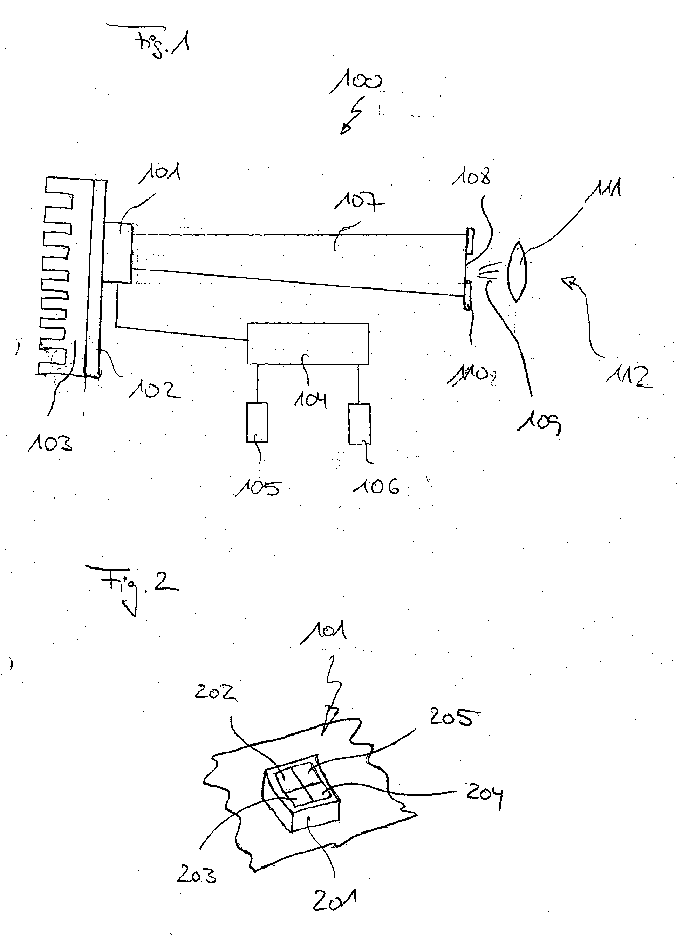

Das Beleuchtungsmodul 100 aus Fig. 1 enthält ein Chip-Mischmodul 101, das auf einem Trägersockel 102 angeordnet ist, der mit einer Kühleinheit 103 verbunden ist. In dem Chip-Mischmodul 101 sind zwei Weißlicht-LEDs sowie eine Rotlicht (R) und eine Grünlicht (G)-LED als Lichtquelle angeordnet.

Das Chip-Mischmodul 101 ist mit einer Steuereinheit 104 verbunden. Dieser Steuereinheit 104 ist ein Datenspeicher 105 und eine Eingabeeinheit 106 zugeordnet. Die Steuereinheit 104 steuert den Stromfluss durch die beiden Weißlicht-LEDs und die Rotlicht-LED (R) und Grünlicht-LED (G) im Chip-Mischmodul 101.

Im Beleuchtungsmodul 100 gelangt das aus dem Chip-Mischmodul 101 austretende Licht durch einen Integratorstab 107. Der Integratorstab 107 wirkt als Lichtmischeinrichtung und homogenisiert das vom Chip-Mischmodul abgegebene Licht. Der Integratorstab 107 ist an seiner Austrittsseite 108, an der Weißlicht 109 aus dem Integratorstab 108 austritt, durch eine Leuchtfeldblende 110 abgeschlossen. Dieser Leuchtfeldblende 110 ist eine Linse 111 mit positiver Brechkraft zugeordnet. Diese Linse 111 mit positiver Brechkraft bildet die Leuchtfeldblende 110 nach unendlich ab, so dass ein paralleler Beleuchtungslichtstrahl am Ausgang 112 des Beleuchtungsmoduls 100 für Licht bereitgestellt wird.

Die Fig. 2 zeigt eine perspektivische Ansicht des Chip-Mischmoduls 101 aus Fig. 1. Das Chip-Mischmodul 101 hat eine Fassung 201, in der eine erste Weißlicht-LED 202, eine zweite Weißlicht-LED 203, eine Rotlicht (R) LED 204 und eine Grünlicht (G) LED 205 aufgenommen sind.

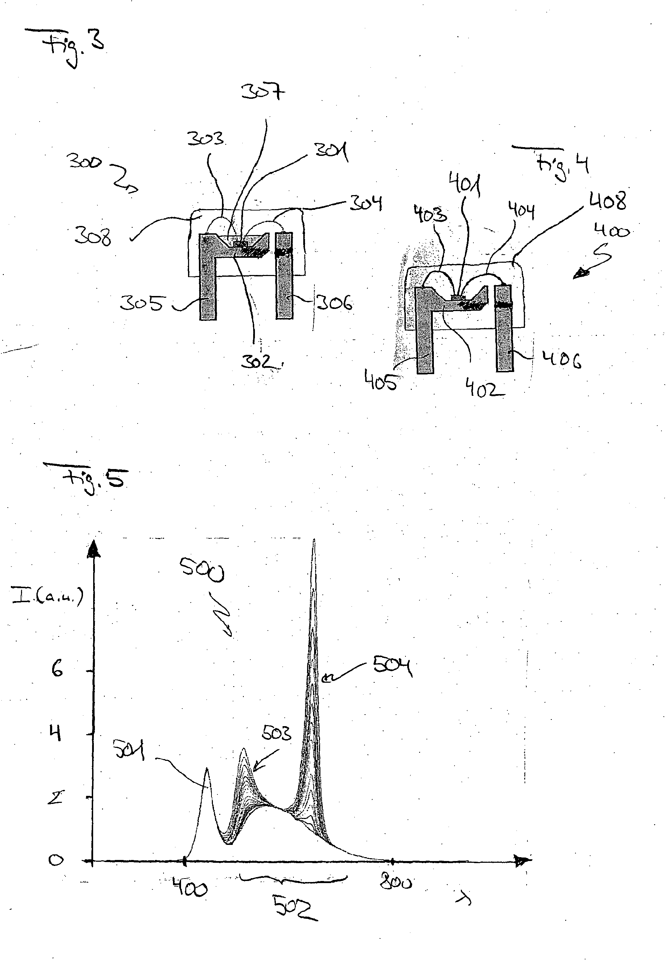

Der schematische Aufbau der Weißlicht-LEDs 202 und 203 im Chip-Mischmodul 101 ist in Fig. 3 dargestellt und wird nachfolgend beschrieben.

Die Weißlicht-LED 300 enthält einen LED-Chip 301, der aus GaInN/GaN besteht. Dieser Chip ist auf einem Trägerkörper 302 angeordnet und mittels Kontaktdrähten 303 und 304 mit einem ersten und einem zweiten elektrischen Anschluss 305, 306 verbunden. In dem Trägerkörper 302 ist der LED-Chip 301 in eine Phosphorschicht 307 eingebettet. Das Funktionsprinzip der Weißlicht-LED ist auf S. 353 in E. Fred Schubert, Light Emitting Diodes, Cambridge University Press, Second Edition 2006 beschrieben: Der LED-Chip 301 gibt blaues Licht ab, das bei Durchdringen der Phosphorschicht 307 gelbes Licht erzeugt, welches sich mit dem blauen LED-Licht zu Weißlicht als additive Spektralfarbenmischung überlagert. Das so erzeugte Weißlicht wird dann durch einen Kunststoffkörper 308, in den die Anordnung eingegossen ist, an die Umgebung abgegeben.

Die Fig. 4 erläutert den Aufbau der Rotlicht (R) LED bzw. der Grünlicht (G) LED im Chip-Mischmodul 101 aus Fig. 1. Die entsprechende LED enthält einen LED-Chip 401. Für die Erzeugung von Rotlicht besteht dieser LED-Chip aus einer AlGaAs/GaAs-Heterostruktur. Grünes Licht kann mit einem LED-Chip aus einer GaAsP:N-Heterostrukur erzeugt werden. Wie im Falle der Weißlicht-LED ist der LED-Chip 401 in einem Trägerkörper 402 angeordnet und mittels Kontaktdrähten 403 und 404 mit ersten und zweiten elektrischen Anschlüssen 405, 406 verbunden. Das vom LED-Chip abgegebene Licht wird durch eine Kunststoffummantelung 408 an die Umgebung abgegeben.

Es ist auch möglich, das Chip-Mischmodul mit Weißlicht-, Rotlicht- und Grünlicht-LEDs auszuführen, die auf einem gemeinsamen Trägersubstrat in dem Chip-Mischmodul platziert sind. Vorzugsweise sind dabei die LEDs mit dem Trägersubstrat von einem gemeinsamen Kunststoffkörper ummantelt.

In Fig. 5 ist mit der Kurve 500 die spektrale Intensität I des vom Beleuchtungsmodul 100 abgegebenen Beleuchtungslichts für verschiedene Stromstärken, die durch die LEDs im Mischmodul geführt werden, in "arbitrary units" (a.u.) gezeigt. Mittels der beiden Weißlicht-LEDs im Mischmodul 101 aus Fig. 1 wird eine Grundhelligkeit des vom Beleuchtungsmodul abgegebenen Weißlichts erzielt. Der Verlauf der spektralen Intensität des von den Weißlicht-LEDs abgegebenen Lichts ist durch ein lokales Maximum 501 im blauen Spektralbereich charakterisiert. Dieses Maximum rührt daher, dass in der Weißlicht-LED das Weißlicht durch Konversion von blauem Licht erzeugt wird, das durch eine Phosphorschicht gelangt und dabei das erzeugte blaue Licht in den Wellenlängenbereich 502 aus Fig. 5 verwandelt.

Die Weißlicht-Leuchtdioden im Chip-Mischmodul 101 aus Fig. 1 werden vorzugsweise für maximale Lichtintensität betrieben.

Durch Einstellen des Stromes, der der Rotlicht (R) LED und der Grünlicht (G) LED zugeführt wird, kann die Intensität des von diesen Leuchtdioden abgegebenen Beleuchtungslichts eingestellt werden um auf diese Weise die Ausprägung der lokalen Maxima 503 und 504 in der spektralen Intensität des vom Beleuchtungsmodul 100 aus Fig. 1 abgegebenen Beleuchtungslichts einzustellen. Auf diese Weise lässt sich die Farbtemperatur des Beleuchtungslichts und der entsprechende CRI-Wert dieses Lichts vaiieren.

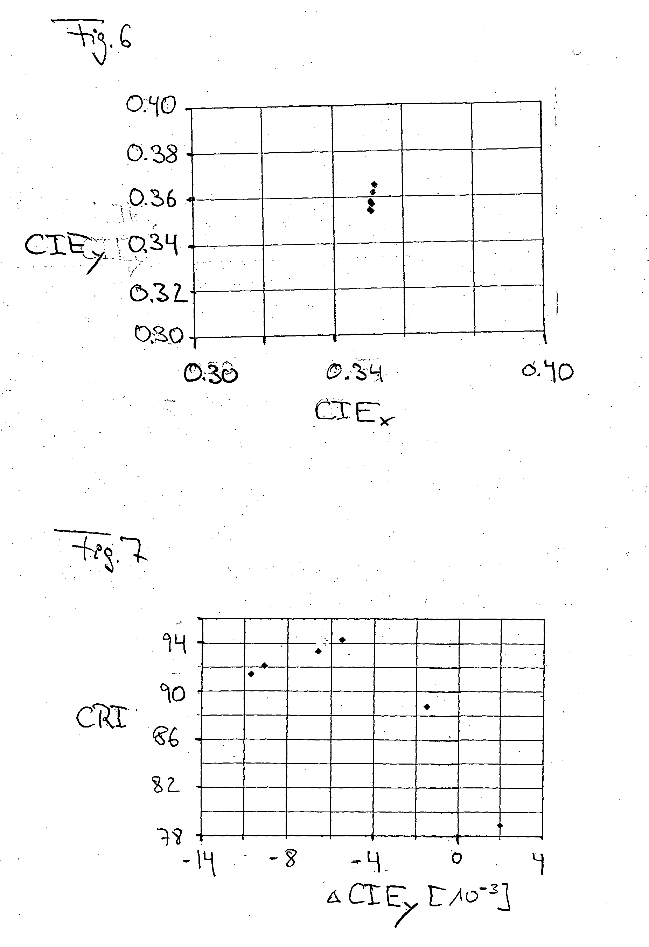

In Fig. 6 ist ein Ausschnitt des auf S. 308 in E. Fred Schubert, Light Emitting Diodes, Cambridge University Press, Second Edition 2006 abgebildeten Farbdreiecks nach dem CIE-Standard gezeigt, in welches für 6 unterschiedliche Werte der integralen relativen Intensität $I_W$, $I_R$ und $I_G$ des von den weißen, roten und grünen LEDs im Chip-Mischmodul 101 aus Fig. 1 die entsprechenden CIE-Wertetupel (CIE$_x$ ; CIE$_y$) für das erzeugte Weißlicht eingezeichnet sind.

Die Farbtemperatur $T_{Farbe}$ des erzeugten Weißlichts liegt dabei im Bereich zwischen 4785° K < $T_{Farbe}$ < 4811° K. Den CIE-Wertetupeln (CIE$_x$ ; CIE$_y$) liegen die in der nachfolgenden Tabelle aufgeführten Werte für die integrale relative Intensität des von den LEDs im Chip-Mischmodul abgegebenen Beleuchtungslichts zugrunde:

Tabelle

| $I_R : I_W : I_G$ | $T_{Farbe}$ °K | (CIE$_x$ ; CIE$_y$) | CRI |
|---|---|---|---|
| 1.34 : 7.40 : 1.05 | 4798 | (0,3519 ; 0,3634) | 78,9 |
| 1.63 : 13.01 : 1.00 | 4785 | (0,3508 ; 03537) | 91,4 |
| 1.63 : 11.67 : 1.09 | 4787 | (0,3511 ; 03568) | 93,3 |
| 1.54 : 9.47 : 1.15 | 4799 | (0,3514 ; 0,3619) | 89,3 |
| 1.57 : 12.54 : 1.00 | 4802 | (0,3504 ; 0,3543) | 92,1 |
| 1.64 : 11.68 : 1.15 | 4811 | (0,3506 ; 0,3579) | 94,3 |

Es zeigt sich, dass bei vergleichsweise unerheblichen Änderungen der Farbtemperatur $T_{Farbe}$ des vom Chipmodul 101 abgegebenen Lichts deutliche Variationen des sich ergebenden CRI-Werts für das generierte Licht anzutreffen sind. Der CRI-Wert des mit den LEDs im Chip-Mischmodul 101 erzeugten Weißlichts für unterschiedliche Werte der entsprechenden relativen integralen Intensitäten $I_R$, $I_W$, und $I_G$ ist in Fig. 7 gezeigt. Dort ist der CRI-Wert des entsprechend generierten Weißlichts gegenüber der Abweichung $\Delta$CIE$_y$ des Werts von CIE$_y$ aus dem CIE-Farbkoordinatentupel (CIE$_x$ ; CIE$_y$) zu dem CIE$_y$ - Wert des schwarzen Temperaturstrahlers bei T = 4800° K aufgetragen. Demnach besteht für den CRI-Wert, der sich durch Variation der relativen Intensität der LEDs im Chip-Mischmodul 101 einstellen lässt, ein Maximum oberhalb von CRI = 94. Mit der entsprechenden Einstellung der relativen integralen Intensität der LEDs im Chip-Mischmodul lässt sich also Weißlicht für optimale Farbwiedergabe erzeugen. Insbesondere lassen sich so für Licht aus dem Beleuchtungsmodul 100 aus Fig. 1 CRI-Werte > 80 einstellen.

Im Datenspeicher 105 des Beleuchtungsmoduls 100 aus Fig. 1 sind für eine vorgegebene Farbtemperatur diejenigen Ströme für die Weißlicht-LED und die Rotlicht und Grünlicht LEDs im Mischmodul 101 des Beleuchtungsmoduls hinterlegt, für die der CRI-Wert maximal ist. Über die Eingabeeinheit 106 im Beleuchtungsmodul 100 kann eine gewünschte Farbtemperatur gewählt werden. Für diese gewählte Farbtemperatur zieht die Steuereinheit 104 die passenden Ströme für die LEDs im Mischmodul 101 heran um Beleuchtungslicht mit einem maximalen CRI-Wert zu erzeugen.

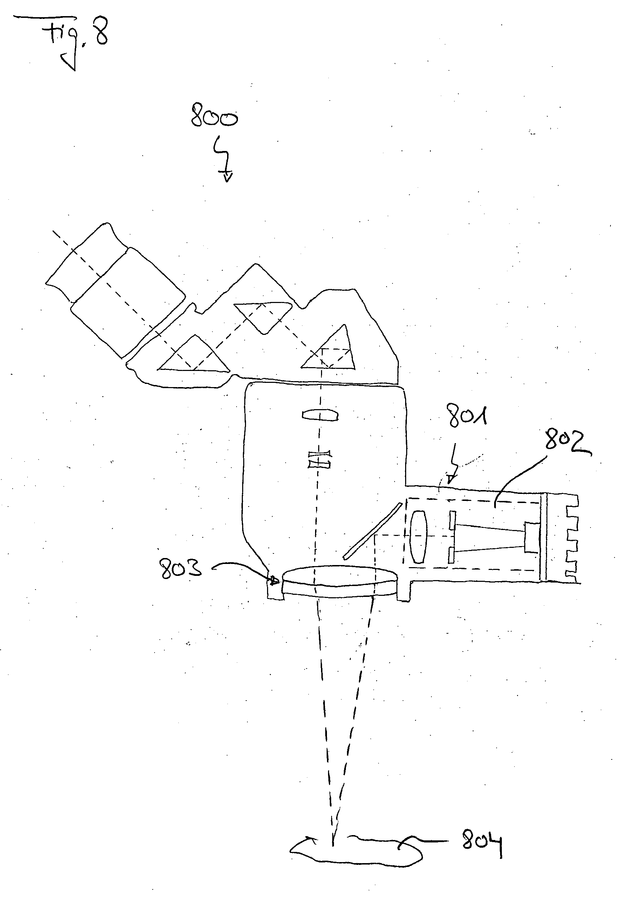

Die Fig. 8 zeigt ein Operationsmikroskop 800, das eine Beleuchtungseinrichtung 801 mit einem Beleuchtungsmodul 802 enthält, das den anhand von Fig. 1 erläuterten Aufbau hat. Die Beleuchtungseinrichtung erzeugt Beleuchtungslicht, das durch das Mikroskop-Hauptobjektiv 803 zum Objektbereich 804 des Operationsmikroskops gelenkt wird, um diesen auszuleuchten.

**Patentansprüche**

1. Beleuchtungsmodul für Beleuchtungslicht

   - mit einer Lichtquelle, die wenigstens eine Weißlicht-LED (202, 203) aufweist,

   **dadurch gekennzeichnet, dass**

   - eine LED für Rotlicht (204) und
   - eine LED für Grünlicht (205) vorgesehen ist, wobei
   - das Beleuchtungsmodul (100) eine Lichtmischeinrichtung enthält, die das Licht der Weißlicht-LED (202, 203) mit Licht der LED für Rotlicht (204) und der LED für Grünlicht (205) vermischt, um an einem Ausgang des Beleuchtungsmoduls (100) weißes Beleuchtungslicht bereitzustellen.

2. Beleuchtungsmodul nach Anspruch 1, **dadurch gekennzeichnet, dass** eine Steuereinheit (104) vorgesehen ist, um die von einer jeden LED (202, 203, 204, 205) abgegebene Lichtintensität zu steuern.

3. Beleuchtungsmodul nach Anspruch 2, **dadurch gekennzeichnet, dass** der Steuereinheit (104) ein Datenspeicher (105) zugeordnet ist, der für unterschiedliche Farbtemperaturen den erforderlichen Strom der LED für Weißlicht (202, 203), der LED für Rotlicht (204) und der LED für Grünlicht (205) enthält, um mit dem Beleuchtungsmodul (100) Weißlicht der betreffenden Farbtemperatur bei maximalem CRI-Wert zu erzeugen.

4. Beleuchtungsmodul nach Anspruch 3, **dadurch gekennzeichnet, dass** das Beleuchtungsmodul (100) eine Eingabeeinheit 106 zur Eingabe einer gewünschten Farbtemperatur des von dem Beleuchtungsmodul (100) abgegebenen Weißlichts aufweist.

5. Operationsmikroskop mit einem Beleuchtungsmodul nach einem der Ansprüche 1 bis 4.

Fig. 1

100

101    107    108    111

102    104    110    112

103    109

105    106

Fig. 2

101

202    205

204

203    201

Fig. 3

307

303    301

300

308    304

305    306

302

Fig. 4

401    404    408

403    400

405    402    406

Fig. 5

I (a.u.)

500

504

6

503

4

501

2

0

400    502    800    λ

Fig. 6

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **E. FRED SCHUBERT.** Light Emitting Diodes. Cambridge University Press, 2006